# EUROPÄISCHE PATENTSCHRIFT

(11) **EP 2 018 094 B1**
(45) Veröffentlichungstag und Bekanntmachung des Hinweises auf die Patenterteilung: **25.04.2012**
(21) Anmeldenummer: 08104450.5
(22) Anmeldetag: 18.06.2008
(51) Int. Cl.: H05K 13/04

(54) **Bestückautomat zum Bestücken von Substraten mit Bauelementen.**
Automatic filling machine for filling substrates with components
Automate d'implantation destiné à implanter des substrats avec des composants

(30) Priorität: 18.07.2007 DE 102007033473
(43) Veröffentlichungstag der Anmeldung: 21.01.2009
(73) Patentinhaber: ASM Assembly Systems GmbH & Co. KG, 81379 München (DE)
(72) Erfinder: Conrad, Robert, 82054, Sauerlach (DE); Mehdianpour, Mohammad, 81829, München (DE); Plattner, Rudolf, 94501, Aldersbach (DE); Stanzl, Harald, 81476, München (DE)
(74) Vertreter: Kuhlmann, Kai

(56) Entgegenhaltungen:
- WO-A-91/11093
- WO-A-2004/080143
- DE-A1- 3 335 905

## Beschreibung

Die Erfindung betrifft einen Bestückautomaten zum Bestücken von Substraten mit Bauelementen.

Bei einem Bestückautomaten zum Bestücken von Substraten mit Bauelementen werden die Bauelemente durch am Bestückautomaten angeordnete Zuführeinrichtungen an definierten Abholpositionen bereitgestellt. Dort werden die Bauelemente von einem Bestückkopf des Bestückautomaten abgeholt und in einen Bestückbereich transferiert, wo sie auf den Substraten positioniert werden. Der Bestückkopf ist an einer Positioniervorrichtung verfahrbar angeordnet. Um eine hohe Bestückleistung zu erreichen wird der Bestückkopf mittels der Positioniervorrichtung stark beschleunigt und abgebremst. Hierbei treten hohe Beschleunigungskräfte auf, welche zu Schwingungen der Positioniervorrichtung führen können, was die Bestückgenauigkeit negativ beeinflusst. Daher wird für die Positioniervorrichtung eine hohe Steifigkeit gefordert.

Aus der Patentschrift EP 1600046 B1 ist eine Vorrichtung zum Bestücken mit elektronischen Bauelementen bekannt, welche einen als Hohlkörper ausgebildeten Träger aus carbonfaserverstärktem Kunststoff (CFK) aufweist, entlang dessen ein Bestückkopf bewegbar ist. Durch die Verwendung von CFK kann eine hohe Steifigkeit des Trägers realisiert werden.

Eine weitere Möglichkeit besteht darin, den Träger aus stranggepressten Aluminiumprofilen oder als gegossenen Aluminiumträger zu fertigen. Die Verwendung von Aluminium wirkt sich im Allgemeinen gewichtsreduzierend auf die Konstruktion aus. Allerdings weisen derartige Aluminiumträger eine geringere Steifigkeit auf als beispielsweise CFK.

Der Erfindung liegt die Aufgabe zugrunde, einen alternativen Bestückautomaten zum Bestücken von Substraten mit Bauelementen bereitzustellen, welcher sich ebenfalls durch eine hohe Steifigkeit auszeichnet.

Diese Aufgabe wird durch den Bestückautomaten gemäß dem unabhängigen Anspruch 1 gelöst. Vorteilhafte Ausgestaltungen sind Gegenstand der abhängigen Ansprüche.

Der Bestückautomat zum Bestücken von Substraten mit Bauelementen gemäß Anspruch 1 verfügt über einen Träger zum Anbringen eines Bestückkopfs, wobei der Träger einen Querschnitt aufweist, welcher aus mindestens 2 Elementen gebildet ist. Die einzelnen Elemente sind dabei mittels Hartlöten miteinander verbunden.

Beim Hartlöten handelt es sich dabei um ein einfaches und kostengünstiges Fügeverfahren für metallische Werkstoffe. Gegenüber Trägern aus stranggepressten Aluminiumprofilen oder Aluminiumguss ergibt sich der Vorteil einer deutlich kompakteren Bauweise bei annähernd gleicher Steifigkeit, so dass der Bestückautomat bei gleichbleibendem Arbeitsbereich deutlich kompakter gestaltet werden kann. Der Bestückkopf muss dabei nicht unmittelbar an dem Träger selbst angebracht sein. Weiterhin können anstelle eines Bestückkopfs auch andere Komponenten, beispielsweise ein optisches Inspektionssystem, eine Klebeeinrichtung oder andere Handhabungseinrichtungen an dem Träger angebracht werden.

Ferner ergibt sich der Vorteil, dass bei Anbringen von Stahl-Führungselementen an dem Träger die Spannungen im Träger, welche bei Temperaturschwankungen von der unterschiedlichen Wärmedehnung der fest miteinander verbundenen Komponentendeutlich verringert werden können. Verformungen aufgrund der Spannungen bei Verwendung verschiedener Materialien (sog. Bimetalleffekt) treten nicht mehr oder deutlich vermindert auf.

Unter Löten wird hier ein thermisches Verfahren zum stoffschlüssigen Fügen von Werkstoffen verstanden, wobei - im Gegensatz zum Schweißen - die Solidustemperatur des Grundwerkstoffs nicht erreicht wird. Grundwerkstoff und Lot bilden dabei eine Legierung und gehen eine feste Verbildung ein. Hierunter fallen auch das sogenannte Hartlöten sowie das Hochtemperaturlöten, wobei das Hochtemperaturlöten eine Unterform des Hartlötens darstellt. Hartlötverbindungen zeichnen sich gegenüber Weichlötverbindungen fast immer durch eine deutlich höhere Festigkeit aus. Zur Erreichung einer qualitativ hochwertigeren Lötverbindung kann der Lötprozess unter Vakuum oder Schutzgas durchgeführt werden. Beim Vakuum-Hochtemperaturlöten ergibt sich ferner der Vorteil, dass das gefertigte Werkstück gleichzeitig spannungsfrei geglüht wird. Damit kann das Werkstück durch Fräsen, Schleifen, etc. nachbearbeitet werden, ohne dass zusätzliche Richtprozesse notwendig werden, um den entstandenen Verzug zu korrigieren.

Der Träger ist Teil eines Positioniersystems, mittels welchem der Bestückkopf verfahrbar ist.

Da der Träger aufgrund seiner Konstruktion sich durch eine gute Steifigkeit bei relativ geringer Masse auszeichnet, ist er als bewegtes Element eines Positioniersystems besonders geeignet.

Bei einer Ausgestaltung des Bestückautomaten gemäß Anspruch 2 sind die einzelnen, den Querschnitt des Trägers bildenden Elemente als Metallplatten ausgebildet.

In einer weiteren Ausgestaltung des Bestückautomaten gemäß Anspruch 3 sind die beiden, den Querschnitt des Trägers bildenden Elemente als L-Profile ausgebildet.

Die Ausführungsformen des Trägerquerschnitts nach einem der Ansprüche 2 oder 3 bieten den Vorteil, dass die einzelnen Komponenten des Trägers einfach und kostengünstig aus sogenannten Halbzeugen, genormtem und vorgefertigtem Rohmaterial, wie Blechen oder Profilen, hergestellt werden können. Derartige Halbzeuge sind preiswert zu beziehen und müssen zur Weiterverarbeitung lediglich noch auf das benötigte Maß zugeschnitten werden. Die L-Profile können sowohl als Halbzeug eingesetzt, als auch durch Abkanten von Blechmaterial einfach und kostengünstig selbst hergestellt werden.

Bei einer Ausgestaltung des Bestückautomaten gemäß Anspruch 4 weist der Träger einen symmetrischen Querschnitt auf.

Da der beim Lötprozess induzierte Energieeintrag in der Aufheiz- und Abkühlphase durch Wärmedehnung zu Verformungen des Werkstücks führen kann, wird der Träger vorzugsweise symmetrisch ausgeführt. Die Verformungen beim Lötprozess infolge Erwärmung lassen sich damit deutlich reduzieren.

In einer Ausgestaltung des Bestückautomaten gemäß Anspruch 5 sind im Bereich mindestens einer Außenfläche des Trägers Lastaufnahmemittel zur Aufnahme von Lasten vorgesehen.

Mithilfe der Lastaufnahmemittel (z.B. Gewindebuchsen) können beispielsweise Antriebs- und Führungselemente des Motors zum Verfahren des Bestückkopfs oder anderer Handhabungseinrichtungen befestigt werden. Werden diese Lastaufnahmemittel bereits bei beim Zusammenfügen des Trägers eingebracht, so erübrigt sich ein nachträgliches Befestigen am Träger.

In einer Ausgestaltung des Bestückautomaten gemäß Anspruch 6 ist der Träger als Hohlkörper ausgebildet und weist in seinem Inneren Versteifungselemente in Form von Metallplatten, vorzugsweise im Bereich der Lastaufnahmemittel, auf.

Durch das Einbringen von Versteifungselementen in das Innere des Trägers im Bereich der Lastaufnahmemittel wird der Träger gezielt in den Bereichen verstärkt, in denen aufgrund der Lastangriffspunkte höhere Kräfte wirken. Hierdurch kann der Träger einerseits sehr steif, andererseits aber kompakter und leichter ausgeführt werden als beispielsweise durch Verwendung eines Hohlprofils ohne entsprechende Versteifungselemente.

Bei einer Ausgestaltung des Bestückautomaten gemäß Anspruch 7 weisen die Versteifungselemente Aussparungen auf.

Durch die Öffnungen, die sinnvoller Weise in den Bereichen angeordnet werden, in denen ein eher geringer Krafteintrag erfolgt, kann die bewegte Masse des Positioniersystems reduziert werden, was sich vorteilhaft auf das Schwingungsverhalten und damit die Bestückgenauigkeit auswirkt.

In einer Ausgestaltung des Bestückautomaten gemäß Anspruch 8 ist der Träger an eine Grundplatte, welche an einem Querträger verfahrbar angeordnet ist, angegossen.

Zur Anbindung des Trägers an das Antriebssystem des Querträgers benötigt der Träger an seiner einen Seite einen Formkörper bzw. ein Verbindungselement, beispielsweise ein Flansch. Das Angießen eines derartigen Flansches ist präzise, da spielfrei, und kostengünstig im Vergleich zu anderen Verbindungstechniken wie beispielsweise Schraubverbindungen.

Im Folgenden wird die Erfindung anhand von Ausführungsbeispielen unter Bezug auf die beigefügten Figuren näher erläutert. Dabei zeigen:
- Figur 1: eine schematische Darstellung eines Bestückautoma- ten
- Figuren 2a,2b: schematische Darstellungen eines ersten Ausfüh- rungsbeispiels des Trägers
- Figuren 3a,3b,3c: schematische Schnittdarstellungen verschiedener weiterer Ausführungsbeispiele des Trägers

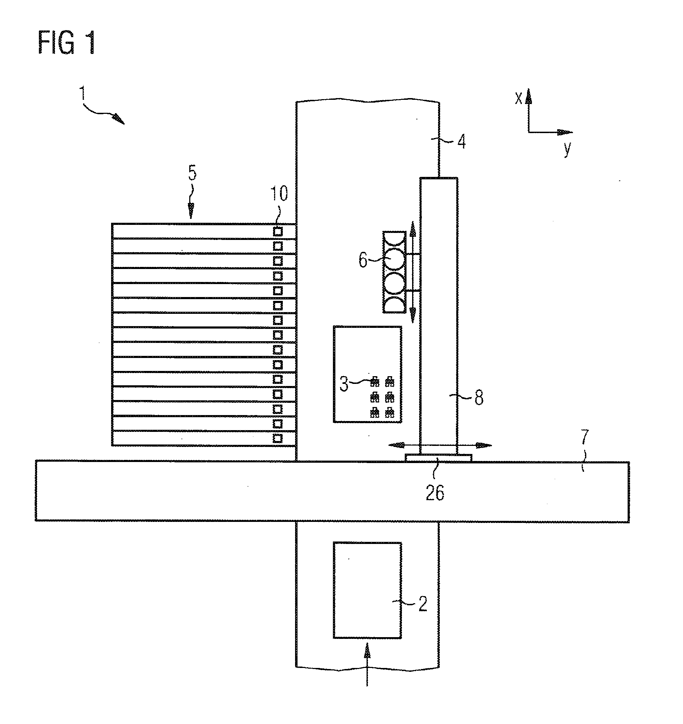

Figur 1 zeigt schematisch einen Bestückautomaten 1 zum Bestücken von Substraten 2 mit Bauelementen 3. Der Bestückautomat 1 besteht aus einem Querträger 7, welcher sich in einer y-Richtung erstreckt und fest mit einem Maschinengestell (nicht dargestellt) verbunden ist. Am Querträger 7 ist ein Träger 8 angebracht, welcher sich in x-Richtung erstreckt und in y-Richtung verschiebbar am Querträger 7 befestigt ist. Querträger 7 und Träger 8 bilden zusammen die Positioniervorrichtung, wobei durch die x-Achse und die y-Achse ein orthogonales Bezugssystem gebildet wird. Am Träger 8 ist ein Bestückkopf 6 in x-Richtung verschiebbar angebracht. Weiterhin ist eine Transportstrecke 4 zum Transport der Substrate 2 in einen Bestückbereich des Bestückautomaten 1 vorgesehen. Seitlich der Transportstrecke 4 sind Zuführvorrichtungen 5 in einem Abholbereich des Bestückautomaten 1 angeordnet, mittels derer die Bauelemente 3 bereitgestellt werden.

Zum Bestücken werden die Substrate 2 über die Transportstrecke 4 in den Bestückbereich des Bestückautomaten 1 transportiert. Die von den Zuführvorrichtungen 5 an Abholpositionen 10 bereitgestellten Bauelemente 3 werden von dem Bestückkopf 6 abgeholt und in den Bestückbereich des Bestückautomaten 1 transferiert, wo sie auf dem Substrat 2 positioniert werden.

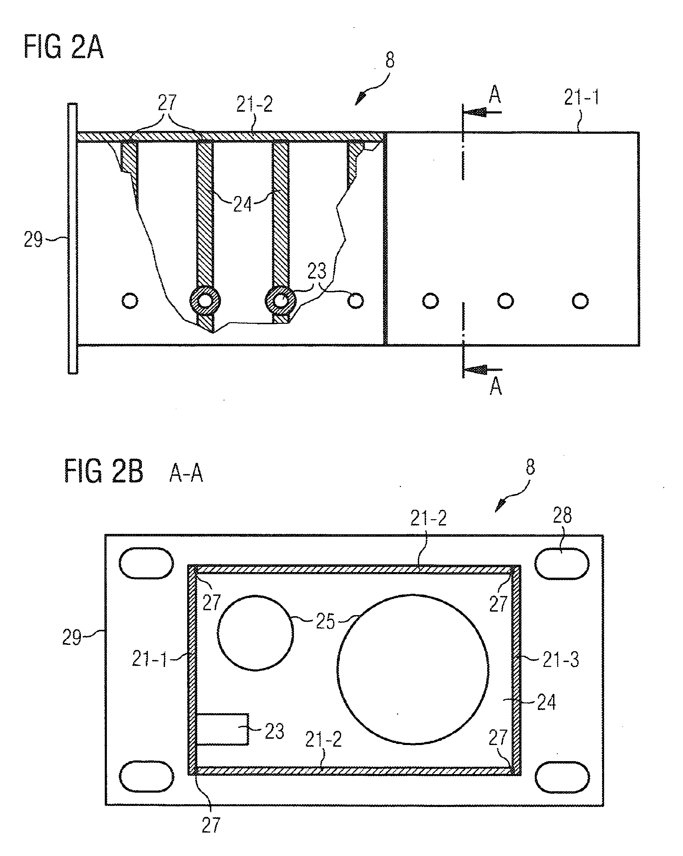

In den Figuren 2a und 2b ist ein Ausführungsbeispiel des Trägers 8 dargestellt. Der Träger 8 ist dabei als Hohlkörper ausgebildet, wobei der Grundkörper des Trägers 8 aus vier Metallplatten 21 gebildet wird, welche durch eine Hartlötverbindung stoffschlüssig miteinander verbunden sind. Vorzugsweise besteht der Träger aus einer Stahllegierung, als Lot kommt beispielsweise Kupfer in Frage.

Figur 2a zeigt eine Seitenansicht des Trägers 8 im Teilschnitt. Die Lastaufnahmeelemente 23 sind hierbei als Gewindebuchsen 23 ausgeführt und an eine der Metallplatten 21 des Trägers angesetzt. Im Bereich der Lastaufnahmeelemente 23 ist die Struktur des Trägers 8 mit Versteifungselementen 24 verstärkt, welche hier ebenfalls als Bleche im Hohlraum des Trägers 8 ausgebildet sind. Im Bereich der Gewindebuchsen 23 sind die Versteifungselemente 24 derart ausgeschnitten, dass die Gewindebuchsen 23 beim Hartlöten sowohl mit der Metallplatte 21-1 als auch mit dem jeweils zugeordneten Versteifungselement 24 verbunden werden. Hierdurch kann der Träger 8 bei vergleichsweise geringen Außenabmessungen relativ steif gestaltet werden. An den Gewindebuchsen 23 können Führungs- oder Antriebselemente eines Motors (nicht dargestellt), beispielsweise Führungsschienen oder Permanentmagnete eines Linearantriebs, zum Verfahren des Bestückkopfs befestigt werden.

Am linken Ende des Trägers ist ein Flansch 29 angeordnet, über den der Träger 8 an das Antriebssystem des Querträgers 7 (siehe Figur 1) angebunden werden kann.

Figur 2b zeigt einen Schnitt (A-A) durch den Träger 8 zwischen zwei Lastaufnahmeelementen 23. Dabei ist gut zu erkennen, dass der Grundkörper des Trägers 8 aus den vier Metallplatten 21-1, 21-2, 21-3 und 21-4 gebildet wird, welche durch Hartlötverbindungen 27 zusammengefügt sind. An die Metallplatte 21-1 ist eine Gewindebuchse 23 als Befestigungselemente angefügt. Das Versteifungselement 24, welches ebenfalls als Metallplatte ausgebildet ist, befindet sich in einer Längserstreckung des Trägers 8 (siehe Figur 2a) auf Höhe der Gewindebuchse 23 und ist am Umfang mit den vier Metallplatten 21 mittels einer Hartlötverbindung verbunden. Zur Reduzierung des Gewichts des Trägers 8 weist das Versteifungselement 24 Aussparungen 25 auf. Diese sind in den Bereichen angeordnet, in denen ein eher geringer Krafteintrag in den Träger 8 stattfindet. Da die dynamischen Kräfte, die durch das Verfahren des Bestückkopfs 6 (siehe Figur 1) auftreten, über die Führungs- oder Antriebselemente des Motors (nicht dargestellt) und damit über die Lastaufnahmeelemente 23 in den Träger 8 eingeleitet werden, sind im unmittelbaren Bereich um die Gewindebuchsen 23 keine Öffnungen im Versteifungselement 24 vorgesehen.

Der Flansch 29 kann ebenfalls als Versteifungselement 24 angesehen werden, dient aber darüber hinaus der Anbindung des Trägers 8 an den Querträger 7. Diese Anbindung kann beispielsweise mittels einer Verschraubung über die in den Eckbereichen des Flansches 29 vorgesehenen Langlöcher 28 in einen Schlitten des Querträgers 7 erfolgen. Es ist jedoch auch möglich, den Träger 8 mitsamt dem Flansch 29 an eine Grundplatte 26 (siehe Figur 1), welche verfahrbar am Querträger 7 angeordnet ist, anzugießen.

In den Figuren 2a und 2b ist nur eine Reihe von Lastaufnahmeelementen 23 dargestellt. Es ist jedoch ebenso möglich, weitere Reihen auf der gleichen oder einer der anderen Metallplatten 21 vorzusehen.

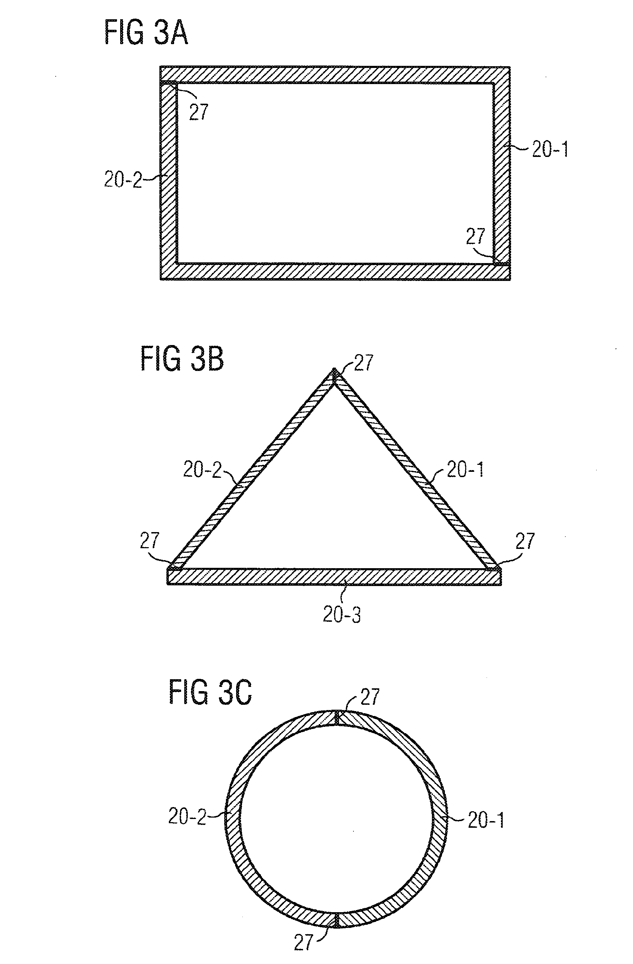

In den Figuren 3a, 3b und 3c sind weitere, mögliche Querschnittsformen des Trägers 8 schematisch dargestellt.

Figur 3a zeigt den Querschnitt eines Trägers 8, welcher aus zwei L-Profilen zusammengesetzt ist. Die Profile können dabei entweder als stranggepresstes Halbzeug bezogen oder aus Blech durch Abkanten hergestellt sein. Die beiden L-Profile sind nur an zwei Nähten durch eine Hartlötverbindung 27 verbunden.

Figur 3b zeigt einen Trägerquerschnitt, welcher die Form eines Dreiecks aufweist und aus drei Metallblechen hergestellt ist. Die Bleche sind wiederum an den Stößen durch Hartlötverbindung 27 verbunden.

Figur 3c eine weitere mögliche Gestaltungsform für einen Trägerquerschnitt. Dabei ist der Träger aus zwei Halbzylindern aufgebaut, welche ebenfalls an den Stoßnähten durch Hartlötverbindung 27 verbunden sind. Diese Form zeichnet sich bei einer außen angreifenden Last durch eine ausgeglichenere Spannungsverteilung über den Trägerquerschnitt aus.

Wie auch schon im ersten in den Figuren 2a und 2b dargestellten Ausführungsbeispiel kann die Steifigkeit des Trägers 8 dadurch erhöht werden, dass in das Innere des mehrteiligen Grundprofils Versteifungselemente eingebracht werden. Dies erfolgt sinnvoller Weise im Bereich der Lastangriffspunkte.

### Bezugszeichenliste:

- 1: Bestückautomat
- 2: Substrat
- 3: Bauelement
- 4: Transportstrecke
- 5: Zuführvorrichtung
- 6: Bestückkopf
- 7: Querträger
- 8: Träger
- 10: Abholposition

- 20: Element
- 21: Metallplatte
- 22: L-Profil
- 23: Lastaufnahmemittel
- 24: Versteifungselement
- 25: Aussparungen
- 26: Grundplatte
- 27: Hartlötverbindung
- 28: Langloch
- 29: Flansch

## Patentansprüche

1. Bestückautomat (1) zum Bestücken von Substraten (2) mit Bauelementen (3), mit einem Träger (8) zum Anbringen eines Bestückkopfes (6), wobei
- der Träger (8) einen Querschnitt aufweist, welcher aus mindestens zwei Elementen (20) gebildet ist,
- die einzelnen Elemente (20) mittels Hartlöten miteinander verbunden sind,
- der Träger (8) ein bewegbares Element einer Positioniervorrichtung (7,8) ist, mittels welcher der Bestückkopf (6) verfahrbar ist.

2. Bestückautomat (1) nach Anspruch 1,
wobei die einzelnen, den Querschnitt des Trägers (8) bildenden Elemente (20) als Metallplatten (21) ausgebildet sind.

3. Bestückautomat (1) nach Anspruch 1,
wobei die beiden, den Querschnitt des Trägers (8) bildenden Elemente (20) als L-Profile (22) ausgebildet sind.

4. Bestückautomat (1) nach einem der Ansprüche 1 bis 3, wobei der Träger (8) einen symmetrischen Querschnitt aufweist.

5. Bestückautomat (1) nach einem der Ansprüche 1 bis 4, wobei im Bereich mindestens einer Außenfläche des Trägers (8) Lastaufnahmemittel (23) zur Aufnahme von Lasten vorgesehen sind.

6. Bestückautomat (1) nach einem der Ansprüche 1 bis 5, wobei der Träger (8) als Hohlkörper ausgebildet ist und in seinem Inneren Versteifungselemente (24), vorzugsweise im Bereich der Lastaufnahmemittel (23), vorgesehen sind.

7. Bestückautomat (1) nach Anspruch 6,
wobei die Versteifungselemente (24) Aussparungen (25) aufweisen.

8. Bestückautomat (1) nach einem der Ansprüche 1 bis 7, wobei der Träger (8) an seinem einen Ende an eine Grundplatte (26), welche an einem Querträger (7) verfahrbar angeordnet ist, angegossen ist.

## Claims

1. Mounting machine (1) for mounting structural elements (3) to substrates (2), with a carrier (8) for attaching a placement head (6), wherein
- the carrier (8) has a cross-section formed by at least two elements (20),
- the single elements (20) are connected with each other by brazing,
- the carrier (8) is a moveable element of a positioning device (7, 8), by means of which the placement head (6) is moveable.

2. Mounting machine (1) according to claim 1,
wherein the single elements (20) forming the cross section of the carrier (8) are made as metal plates (21).

3. Mounting machine (1) according to claim 1,
wherein the two elements (20) forming the cross section of the carrier (8) are shaped as L-profiles (22).

4. Mounting machine (1) according to any one of claims 1 to 3, wherein the carrier (8) has a symmetrical cross section.

5. Mounting machine (1) according to any one of claims 1 to 4, wherein in the area of at least one outer surface of the carrier (8) load-bearing devices (23) for bearing loads are provided.

6. Mounting machine (1) according to any one of claims 1 to 5, wherein the carrier (8) is shaped as hollow body and in its interior stiffening elements (24), preferably in the region of the load-bearing devices (23), are provided.

7. Mounting machine (1) according to claim 6,
wherein the stiffening elements (24) have recesses (25).

8. Mounting machine (1) according to any one of claims 1 to 7, wherein the carrier (8) at one of its ends is cast on a base plate (26), which is moveably arranged on a cross member (7).

## Revendications

1. Appareil de garnissage automatisé (1) conçu pour garnir des substrats (2) à l'aide de composants (3), muni d'un support (8) dévolu à l'installation d'une tête de garnissage (6), dans lequel
- ledit support (8) présente une section transversale constituée d'au moins deux éléments (20),
- les éléments (20) individuels sont reliés mutuellement par brasage fort,
- ledit support (8) se présente comme un élément mobile d'un dispositif de positionnement (7, 8) au moyen duquel la tête de garnissage (6) peut être déplacée.

2. Appareil de garnissage automatisé (1) selon la revendication 1,
dans lequel les éléments (20) individuels, constituant la section transversale du support (8), sont réalisés sous la forme de platines métalliques (21).

3. Appareil de garnissage automatisé (1) selon la revendication 1,
dans lequel les deux éléments (20), constituant la section transversale du support (8), sont réalisés sous la forme de profilés en L (22).

4. Appareil de garnissage automatisé (1) selon l'une des revendications 1 à 3,
dans lequel le support (8) présente une sections transversale symétrique.

5. Appareil de garnissage automatisé (1) selon l'une des revendications 1 à 4,
dans lequel des moyens (23) récepteurs de charges sont prévus dans la région d'au moins une surface extérieure du support (8), afin de recevoir des charges.

6. Appareil de garnissage automatisé (1) selon l'une des revendications 1 à 5,
dans lequel le support (8) est réalisé sous la forme d'un corps creux et des éléments de rigidification (24) sont prévus dans son espace intérieur, de préférence dans la région des moyens (23) récepteurs de charges.

7. Appareil de garnissage automatisé (1) selon la revendication 6,
dans lequel les éléments de rigidification (24) comportent des évidements (25).

8. Appareil de garnissage automatisé (1) selon l'une des revendications 1 à 7,
dans lequel le support (8) est venu de fonderie, à l'une de ses extrémités, avec une plaque de semelle (26) agencée avec mobilité sur un support transversal (7).
